(19) **Europäisches Patentamt / European Patent Office / Office européen des brevets**

(11) **EP 3 783 376 B1**

(12) **EUROPEAN PATENT SPECIFICATION**

(45) Date of publication and mention
of the grant of the patent:
**27.04.2022 Bulletin 2022/17**

(21) Application number: **18915192.1**

(22) Date of filing: **17.04.2018**

(51) International Patent Classification (IPC):
**G01R 31/34** (2020.01)    **G01R 31/52** (2020.01)

(52) Cooperative Patent Classification (CPC):
**G01R 31/343; G01R 19/02; G01R 19/16571;
G01R 31/52**

(86) International application number:
**PCT/JP2018/015822**

(87) International publication number:
**WO 2019/202651 (24.10.2019 Gazette 2019/43)**

(54) **ELECTRIC MOTOR DIAGNOSING DEVICE**

DIAGNOSEVORRICHTUNG FÜR ELEKTROMOTOR

DISPOSITIF DE DIAGNOSTIC DE MOTEUR ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**24.02.2021 Bulletin 2021/08**

(73) Proprietor: **Mitsubishi Electric Corporation
Tokyo 100-8310 (JP)**

(72) Inventors:
• **MIYAUCHI, Toshihiko
Tokyo 100-8310 (JP)**
• **KANEMARU, Makoto
Tokyo 100-8310 (JP)**

(74) Representative: **Witte, Weller & Partner
Patentanwälte mbB
Postfach 10 54 62
70047 Stuttgart (DE)**

(56) References cited:
WO-A1-2017/081908    CN-A- 106 291 352
JP-A- 2012 186 973    JP-B1- S 504 857
JP-B2- 6 099 852

• **DAS SANTANU ET AL: "Characterization of short circuit faults and incipient insulation degradation between stator winding turns of induction motor", 2013 IEEE 1ST INTERNATIONAL CONFERENCE ON CONDITION ASSESSMENT TECHNIQUES IN ELECTRICAL SYSTEMS (CATCON), IEEE, 6 December 2013 (2013-12-06), pages 54-59, XP032565092, DOI: 10.1109/CATCON.2013.6737473 [retrieved on 2014-02-11]**
• **BAKHRI S ET AL: "Practical issues on negative sequence current monitoring for condition monitoring in induction motors", UNIVERSITIES POWER ENGINEERING CONFERENCE (AUPEC), 2012 22ND AUSTRALASIAN, IEEE, 26 September 2012 (2012-09-26), pages 1-6, XP032271812, ISBN: 978-1-4673-2933-0**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Processed by Luminess, 75001 PARIS (FR)

**Description**

TECHNICAL FIELD

The present disclosure relates to an electric motor diagnosing device.

BACKGROUND ART

There are a lot of electric motors in a plant, and diagnosis for the equipment thereof is conducted by person's senses in a maintenance department. In particular, for electric motors which are of high importance, regular diagnosis is needed and thus the cost increases. Further, in an electric motor, a gap or damaged part of an insulation material caused by mechanical stress and thermal deterioration induces layer short-circuit through discharge or the like and this can suddenly lead to insulation breakage. Therefore, once deterioration in an electric motor begins, the deterioration is only going to progress further.

Accordingly, there is increasing interest in technology for constantly monitoring electric motors. However, many of electric motor constantly monitoring technologies are based on the premise that various measurement devices such as sensors are attached for each electric motor. The measurement devices are, for example, a torque meter, an encoder, an acceleration sensor, and the like. However, application to a motor control center which performs centralized management for hundreds to thousands of motors is not realistic because the number of wires increases. Therefore, there is a need for a device that is capable of simply diagnosing the states of electric motors on the basis of information about current and voltage measured in a motor control center without using special sensors, and achieves improved reliability, productivity, and safety.

In this regard, the applicant has proposed an electric motor diagnosing device including an electric motor, a diagnosing device, a current sensor, and a voltage sensor (see Patent Document 1). The electric motor diagnosing device is provided with a current detection circuit for detecting current and a voltage detection circuit for detecting voltage of the electric motor on the basis of voltage of a main circuit of a power supply, and performs determination and detection for winding short-circuit while distinguishing power supply imbalance even when load torque varies during operation of the electric motor, on the basis of negative-phase-sequence current, negative-phase-sequence voltage, positive-phase-sequence current, and negative-phase-sequence admittance.

Patent Document 2 relates to a motor fault detection method and device and a motor fault protection system. The motor fault detection method comprises the steps that motor current is acquired; a motor negative sequence current value is acquired based on motor current; and whether the motor fails to work is determined based on the size relation between the motor negative sequence current value and a preset threshold. According to the motor fault detection method and device and the motor fault protection system, fault detection is performed based on the negative sequence current component included in instantaneous alternating current of the motor with no requirement for performing long time of instantaneous current acquisition or complex operation so that the motor fault can be detected in real time, fault protection delay can be shortened and safer and more efficient fault protection can be realized.

Non- Patent Document 1 relates to characterization of short circuit faults and incipient insulation degradation between stator winding turns of induction motor.

Non- Patent Document 2 relates to practical issues on negative sequence current monitoring for condition monitoring in induction motors.

CITATION LIST

PATENT DOCUMENT

Patent Document 1: Japanese Patent No. 6099852
Patent Document 2: CN 106 291 352 A

NON- PATENT DOCUMENT

Non- Patent Document 1: DAS SANTANU ET AL: "Characterization of short circuit faults and incipient insulation degradation between stator winding turns of induction motor", 2013 IEEE 1ST INTERNATIONAL CONFERENCE ON CONDITION ASSESSMENT TECHNIQUES IN ELECTRICAL SYSTEMS (CATCON), IEEE, 6 December 2013 (2013-12-06), pages 54-59, XP032565092, DOI: 10.1109/CATCON.2013.6737473

Non- Patent Document 2: BAKHRI S ET AL: "Practical issues on negative sequence current monitoring for condition monitoring in induction motors", UNIVERSITIES POWER ENGINEERING CONFERENCE (AUPEC), 2012 22ND AUSTRALASIAN, IEEE, 26 September 2012 (2012-09-26), pages 1-6, XP032271812, ISBN: 978-1-4673-2933-0

## SUMMARY OF THE INVENTION

## PROBLEMS TO BE SOLVED BY THE INVENTION

In short-circuit diagnosis for stator windings in the electric motor diagnosing device disclosed in Patent Document 1, determination for winding short-circuit is performed on the basis of an evaluation value A using the negative-phase-sequence admittance (A = |Isn - Yn·Vsn| in Expression (10) of Patent Document 1, where Isn is negative-phase-sequence current, Yn is negative-phase-sequence admittance, and Vsn is negative-phase-sequence voltage). Here, in calculating initial negative-phase-sequence admittance Yn, if the power supply imbalance is small, the negative-phase-sequence current value is small, so that error of the negative-phase-sequence admittance Yn increases. Increase in error of the initial negative-phase-sequence admittance Yn increases error of the value of the second term on the right-hand side of the winding short-circuit evaluation value, and this might lead to erroneous detection of winding short-circuit. Therefore, a method not using the negative-phase-sequence admittance Yn is required.

The present disclosure has been made to solve the above problem, and an object of the present disclosure is to provide an electric motor diagnosing device capable of accurately detecting short-circuit failure in stator windings of an electric motor without calculating negative-phase-sequence admittance.

## SOLUTION TO THE PROBLEMS

An electric motor diagnosing device according to the present disclosure is defined in claim 1.

## EFFECT OF THE INVENTION

The electric motor diagnosing device according to the present disclosure performs determination for winding short-circuit, using, as the evaluation value, the difference between the negative-phase-sequence current calculated from current of the electric motor during driving and the initial negative-phase-sequence current. Thus, negative-phase-sequence admittance is not calculated and therefore short-circuit failure in stator windings of the electric motor can be detected accurately.

## BRIEF DESCRIPTION OF THE DRAWINGS

[FIG. 1] FIG. 1 is a circuit configuration diagram showing an electric motor diagnosing device according to embodiment 1.
[FIG. 2] FIG. 2 conceptually illustrates winding short-circuit.
[FIG. 3] FIG. 3 is a configuration diagram of a calculation processing unit in the electric motor diagnosing device according to embodiment 1.
[FIG. 4] FIG. 4 is a flowchart for analyzing initial negative-phase-sequence current using the electric motor diagnosing device according to embodiment 1.
[FIG. 5] FIG. 5 is a flowchart for performing winding short-circuit determination using the electric motor diagnosing device according to embodiment 1.
[FIG. 6] FIG. 6 is a circuit configuration diagram showing an electric motor diagnosing device according to embodiment 2.
[FIG. 7] FIG. 7 is a configuration diagram of a calculation processing unit in the electric motor diagnosing device according to embodiment 2.
[FIG. 8] FIG. 8 is a flowchart for analyzing initial negative-phase-sequence current using the electric motor diagnosing device according to embodiment 2.
[FIG. 9] FIG. 9 is a flowchart for performing winding short-circuit determination using the electric motor diagnosing device according to embodiment 2.
[FIG. 10] FIG. 10 shows the correspondence relationship between a voltage imbalance rate and negative-phase-sequence current, used in an electric motor diagnosing device according to embodiment 3.

DESCRIPTION OF EMBODIMENTS

Hereinafter, embodiments will be described with reference to the drawings. In the drawings, the same reference characters denote the same or corresponding parts.

Embodiment 1

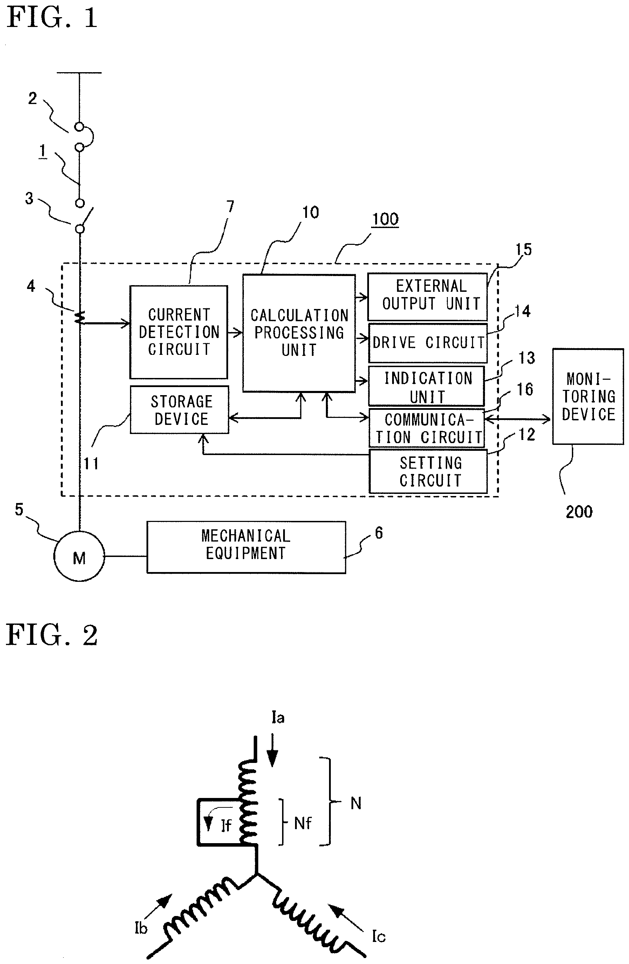

Hereinafter, an electric motor diagnosing device according to embodiment 1 will be described with reference to FIG. 1 to FIG. 5.

FIG. 1 is a circuit configuration diagram showing the electric motor diagnosing device according to embodiment 1, which is mainly used in a control center which is an enclosed switchboard. In the drawing, a main circuit 1 of a power supply led from a power system is provided with a circuit breaker 2, an electromagnetic contactor 3, and an instrument transformer 4 for detecting load current of the main circuit 1. Further, an electric motor 5 which is a load is connected, and mechanical equipment 6 is driven by the electric motor 5.

An electric motor diagnosing device 100 includes a current detection circuit 7 connected to the instrument transformer 4, a calculation processing unit 10, a storage device 11, a setting circuit 12, an indication unit 13, a drive circuit 14, an external output unit 15, and a communication circuit 16.

The current detection circuit 7 converts load current of the main circuit 1 detected by the instrument transformer 4, to a predetermined signal such as phase current of the electric motor 5, to detect current of the electric motor, and outputs the signal to the calculation processing unit 10 and the storage device 11. That is, the current detection circuit 7 detects current of the electric motor 5 from current flowing through the main circuit 1 of the power supply connected to the electric motor 5.

The calculation processing unit 10 receives output of the current detection circuit 7, and calculates negative-phase-sequence current and the like through analysis on current of the electric motor, to perform determination for winding short-circuit during operation of the electric motor.

The calculation processing unit 10 includes a central processing unit (CPU) as a calculation processing device. As a calculation processing device, various logic circuits such as an application specific integrated circuit (ASIC), an integrated circuit (IC), and a digital signal processor (DSP), various signal processing circuits, and the like may be provided.

The storage device 11 is connected to the calculation processing unit 10 and the setting circuit 12, and transmits/receives data to/from the calculation processing unit 10. The storage device 11 includes a random access memory (RAM) from/into which data can be read/written by the calculation processing unit 10, a read only memory (ROM) or a nonvolatile memory (EEPROM: electrically erasable programmable read only memory) from which data can be read by the calculation processing unit 10, and the like.

The setting circuit 12 connected to the storage device 11 has a set key, and by pressing (e.g., holding down) the set key, data in an initial normal state is stored and retained in the storage device 11. The data can be stored until the set key is canceled.

The indication unit 13 is connected to the calculation processing unit 10, and indicates a detected physical quantity such as load current, and an abnormal state, a warning, and the like when the calculation processing unit 10 has detected abnormality in the electric motor 5.

The drive circuit 14 is connected to the calculation processing unit 10, and outputs a control signal for opening/closing the electromagnetic contactor 3 on the basis of a result of calculation performed by the calculation processing unit 10 on the basis of a current signal detected by the instrument transformer 4.

The external output unit 15 outputs a signal of an abnormal state, a warning, and the like from the calculation processing unit 10, to outside.

An external monitoring device 200 is formed from a personal computer (PC) or the like, and is connected to one or a plurality of electric motor diagnosing devices 100. The external monitoring device 200 receives information of the calculation processing unit 10 via the communication circuit 16 as necessary, and monitors the operation condition of the electric motor diagnosing device 100. Connection between the external monitoring device 200 and the communication circuit 16 of the electric motor diagnosing device 100 may be made using a cable or wirelessly. The connection may be made via the Internet by constructing a network among the plurality of electric motor diagnosing devices 100.

FIG. 2 conceptually illustrates winding short-circuit subjected to diagnosis in the present disclosure. In the drawing, it is assumed that short-circuit occurs in phase a and short-circuit current If flows, and the number of short-circuited winding turns is denoted by Nf. A short-circuit rate $\mu$, which is a ratio of Nf to the number of whole winding turns N, is generalized as shown below:

$$\mu = Nf/N.$$

In addition, in the stator windings of the electric motor 5, either of short-circuit in the same layer and short-circuit between layers can occur. In the present embodiment, these two types of short-circuit are both diagnosed as winding short-circuit.

In the present disclosure, rating information for the electric motor 5 need not be inputted before start of operation.

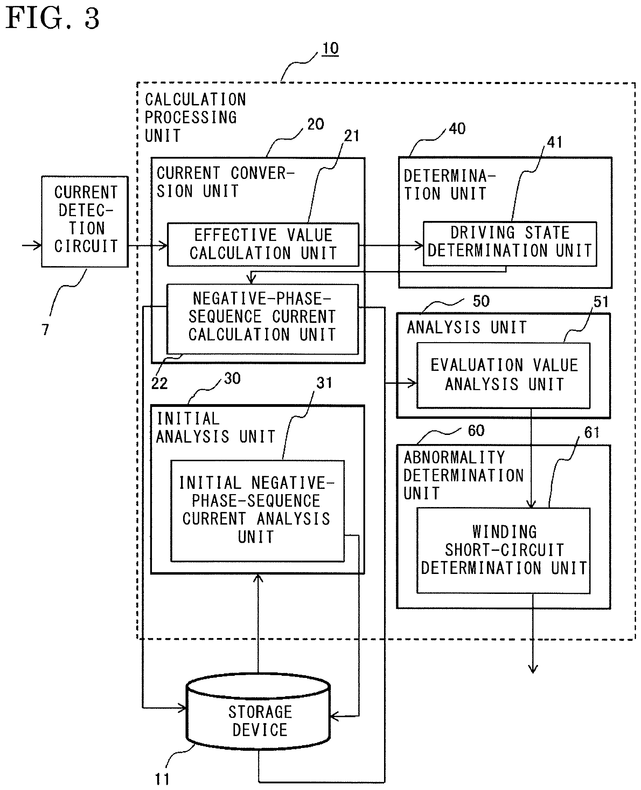

FIG. 3 is a configuration diagram schematically showing the calculation processing unit 10 in the electric motor diagnosing device according to embodiment 1. The calculation processing unit 10 includes a current conversion unit 20, an initial analysis unit 30, a determination unit 40, an analysis unit 50, and an abnormality determination unit 60.

The current conversion unit 20 includes an effective value calculation unit 21 and a negative-phase-sequence current calculation unit 22, and calculates negative-phase-sequence current Isn by the following Expression (1) through symmetric coordinate conversion processing on the basis of three-phase currents detected by the current detection circuit 7.

[Mathematical 1]

$$I_{sn} = \frac{1}{3}\left(I_u + a^2 I_v + a I_w\right) \qquad \cdots (1)$$

$$a = e^{j\frac{2}{3}\pi}$$

Here, Isn is the negative-phase-sequence current, Iu is u-phase current, Iv is v-phase current, and Iw is w-phase current.

The initial analysis unit 30 includes an initial negative-phase-sequence current analysis unit 31. The initial negative-phase-sequence current analysis unit 31 analyzes a negative-phase-sequence current value Isn in a normal state before winding short-circuit determination. For example, negative-phase-sequence current values for one month are calculated, and an averaged value thereof is used as an initial negative-phase-sequence current value Isn0.

The determination unit 40 includes a driving state determination unit 41. The driving state determination unit 41 determines the driving state of the motor on the basis of the effective value of current calculated by the effective value calculation unit 21. Determination for the driving state of the motor may be performed on the basis of, instead of the effective value of current, the instantaneous value of current or an ON/OFF signal of the electromagnetic contactor 3.

The analysis unit 50 includes an evaluation value analysis unit 51, and performs analysis for determination to be performed in a winding short-circuit determination unit 61 of the abnormality determination unit 60. The evaluation value analysis unit 51 calculates an evaluation value A = |Isn - Isn0|.

Next, calculation for the evaluation value A will be described. Winding short-circuit is short-circuit between coil wires. When winding short-circuit occurs, the three-phase stator currents become asymmetric, and therefore detection can be performed from a negative-phase-sequence component. Where the short-circuit rate when winding short-circuit occurs in a part of stator windings of a three-phase induction electric motor is denoted by $\mu$ ($\mu$ = Nf/N) and $\mu$ << 1 is assumed, the following relational expressions are obtained among positive-phase-sequence voltage Vsp, negative-phase-sequence voltage Vsn, positive-phase-sequence current Isp, and negative-phase-sequence current Isn.

[Mathematical 2]

$$\begin{bmatrix} \tilde{I}_{sp} \\ \tilde{I}_{sn} \end{bmatrix} = \begin{bmatrix} Y_{pp} & Y_{pn} \\ Y_{np} & Y_{nn} \end{bmatrix} \begin{bmatrix} \tilde{V}_{sp} \\ \tilde{V}_{sn} \end{bmatrix} \qquad \cdots (2)$$

[Mathematical 3]

$$Y_{pn} = Y_{np} = \frac{\mu^2}{3\left(j\mu\omega L_{ls} + r_f + \mu r_s\right)} \quad \cdots (3)$$

[Mathematical 4]

$$Y_{pp} = Y_p + Y_{pn}$$

$$= \frac{r_r + js\omega L_r}{s\omega^2 L_m^2 + (r_s + j\omega L_s)(r_r + js\omega L_r)} + \frac{\mu^2}{3(j\mu\omega L_{ls} + r_f + \mu r_s)} \quad \cdots (4)$$

[Mathematical 5]

$$Y_{nn} = Y_n + Y_{np}$$

$$= \frac{r_r + j(2-s)\omega L_r}{(2-s)\omega^2 L_m^2 + (r_s + j\omega L_s)(r_r + j(2-s)\omega L_r)} + \frac{\mu^2}{3(j\mu\omega L_{ls} + r_f + \mu r_s)} \quad \cdots (5)$$

Here, Ypp is admittance of a positive phase sequence-positive phase sequence component, Ynn is admittance of a negative phase sequence-negative phase sequence component, Ypn is admittance of a positive phase sequence-negative phase sequence component, Ynp is admittance of a negative phase sequence-positive phase sequence component, Yn is negative-phase-sequence admittance, ω is a power supply angular velocity, rs is stator resistance, rr is rotor resistance, rf is short-circuit resistance, Ls is stator leakage inductance, Lr is rotor leakage inductance, Lm is excitation inductance, and μ is the short-circuit rate.

A non-diagonal component Ypn of the admittance Y can be used as an index for winding short-circuit, but it is not easy to calculate the non-diagonal component Ypn in an actual device. Therefore, here, a method of measuring and monitoring only negative-phase-sequence current Isn by analyzing normal-state data of initial negative-phase-sequence current IsnO, is adopted.

When winding short-circuit does not occur (μ = 0), the non-diagonal component Ypn of the admittance Y is zero, and therefore the following is satisfied.

$$\text{Isn} = \text{Yn·Vsn} = \text{Isn0} \quad ... (6)$$

When winding short-circuit occurs, Isn changes as follows.

$$\text{Isn} = \text{Yn·Vsn} + \text{Ypn·Vsp} = \text{Isn0} + \text{Ypn·Vsp} \quad ... (7)$$

That is, with the initial negative-phase-sequence current Isn0 analyzed, only Isn and Isn0 are measured, and the following evaluation value A is used as an index.

$$\text{Evaluation value A} = |\text{Isn - Isn0}| \quad ... (8)$$

Thus, occurrence of winding short-circuit can be detected.

At the initial period when an electric motor is installed, initialization is performed (negative-phase-sequence admittance Yn is calculated) assuming that winding short-circuit has not occurred yet, and thereafter, the evaluation value A in Expression (8) is monitored to perform determination for winding short-circuit.

The abnormality determination unit 60 includes a winding short-circuit determination unit 61, and determines whether or not winding short-circuit has occurred on the basis of whether or not the evaluation value A calculated by the evaluation value analysis unit 51 exceeds a predetermined threshold δ1. The threshold δ1 is a value that differs depending on the rating of the electric motor 5.

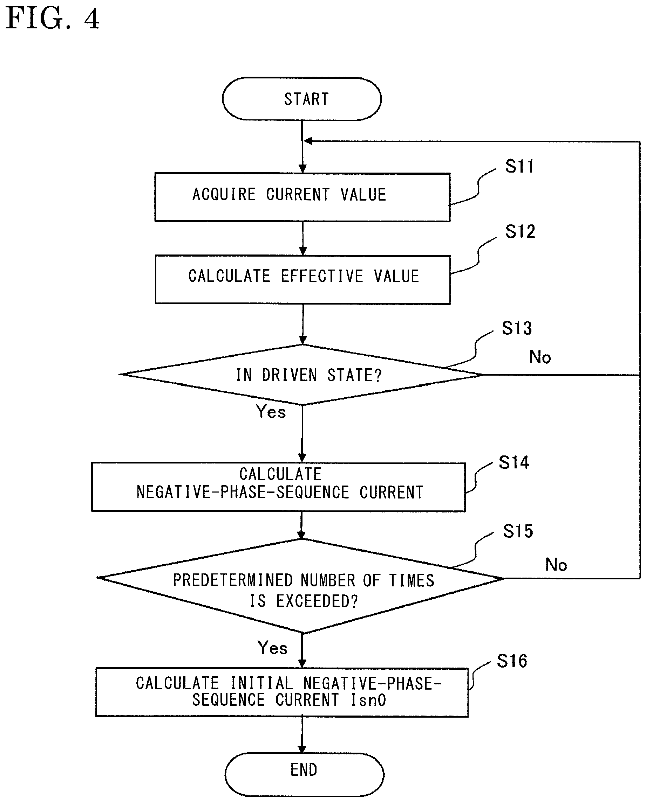

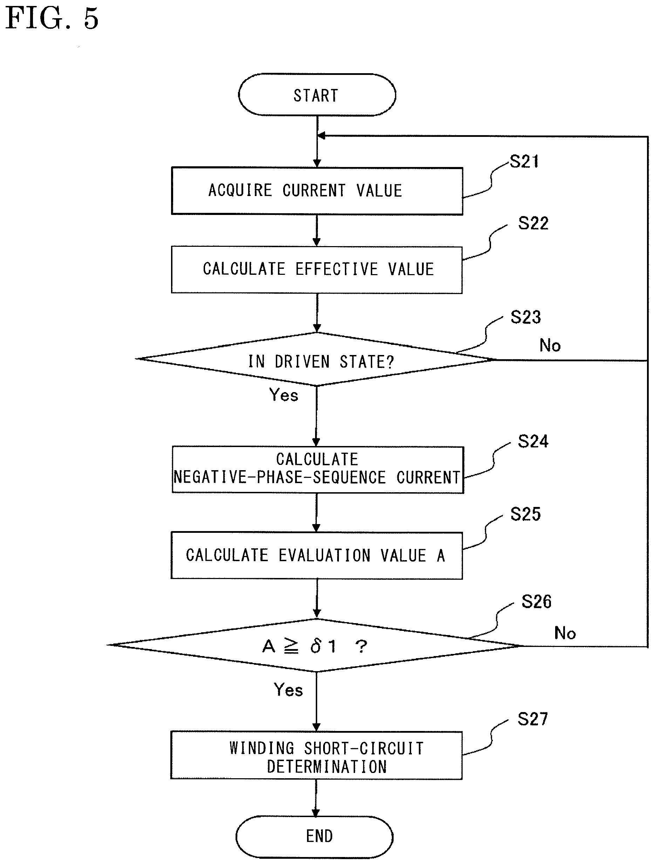

Next, a process for diagnosis using the electric motor diagnosing device 100 will be described with reference to FIG. 4 and FIG. 5.

FIG. 4 is a flowchart for analyzing initial negative-phase-sequence current using the electric motor diagnosing device according to embodiment 1. Current (current for each phase) of the electric motor 5 is acquired by the current detection circuit 7 (step S11), and the effective value calculation unit 21 calculates the effective value of the current (step S12). The driving state determination unit 41 determines whether or not the electric motor 5 is in a driven state, on the basis of the effective value of the current, and if it is determined that the electric motor 5 is in a driven state (Yes in step S13), the negative-phase-sequence current calculation unit 22 calculates negative-phase-sequence current (step S14). Whether or not the number of times the negative-phase-sequence current is calculated exceeds a predetermined number of times, is determined. If it is determined that the predetermined number of times is exceeded (Yes in step S15), the negative-phase-sequence current values for the predetermined number of times are averaged, and the averaged value is used as the initial negative-phase-sequence current value Isn0 (step S16). The initial negative-phase-sequence current value Isn0 is stored in the storage device 11. If the number of times the negative-phase-sequence current is calculated is smaller than the predetermined number of times (No in step S15), current of the electric motor is acquired again to repeat processing from step S11 to step S15 until reaching the predetermined number of times.

After the initial negative-phase-sequence current value Isn0 is calculated, diagnosis for winding short-circuit determination is performed.

FIG. 5 is a flowchart for performing winding short-circuit determination. Current (current for each phase) of the electric motor 5 is acquired by the current detection circuit 7 (step S21), and the effective value calculation unit 21 calculates the effective value of the current (step S22). The driving state determination unit 41 determines whether or not the electric motor 5 is in a driven state, on the basis of the effective value of the current, and if it is determined that the electric motor 5 is in a driven state (Yes in step S23), the negative-phase-sequence current calculation unit 22 calculates negative-phase-sequence current Isn (step S24).

Next, the evaluation value analysis unit 51 calculates the evaluation value A in Expression (8) from the initial negative-phase-sequence current Isn0 calculated in step S16 in FIG. 4 and stored in the storage device 11 and the negative-phase-sequence current Isn calculated in step S24 (step S25). The winding short-circuit determination unit 61 compares the evaluation value A and the predetermined threshold δ1. If $A \geq \delta1$ is satisfied (Yes in step S26), the winding short-circuit determination unit 61 determines that winding short-circuit has occurred, and outputs the result to outside (step S27).

In the case of A < 51 in step S26, the process returns to step S21 to acquire current (current for each phase) of the electric motor 5 again.

As described above, in embodiment 1, a difference from the initial value of the negative-phase-sequence current is used as the evaluation value A for winding short-circuit, and determination for winding short-circuit is performed through comparison between the evaluation value A and the predetermined threshold δ1. Therefore, the initial state can be offset and negative-phase-sequence admittance is not calculated. Thus, it is possible to accurately detect short-circuit failure in the stator windings of the electric motor. In addition, since a voltage detection circuit is not needed, it becomes possible to provide an electric motor diagnosing device capable of accurately detecting short-circuit failure in stator windings of an electric motor while suppressing power consumption, with a simple configuration.

In the present embodiment, it is assumed that the voltage imbalance rate is small. This is because, if the voltage imbalance rate is great, the negative-phase-sequence current value changes depending on variation in load torque, and thus there is a high possibility that erroneous detection occurs in winding short-circuit determination. In a system used in the control center which is an enclosed switchboard, exemplified in the present embodiment, the magnitude of the voltage imbalance rate can be selected in advance on the basis of load balance. In the present embodiment, a system having a small voltage imbalance rate as selected can be adopted. Alternatively, as described later, measurement for the voltage imbalance rate may be performed in parallel, or the value thereof may be acquired in advance, and then whether or not the present embodiment is applicable may be determined.

Embodiment 2

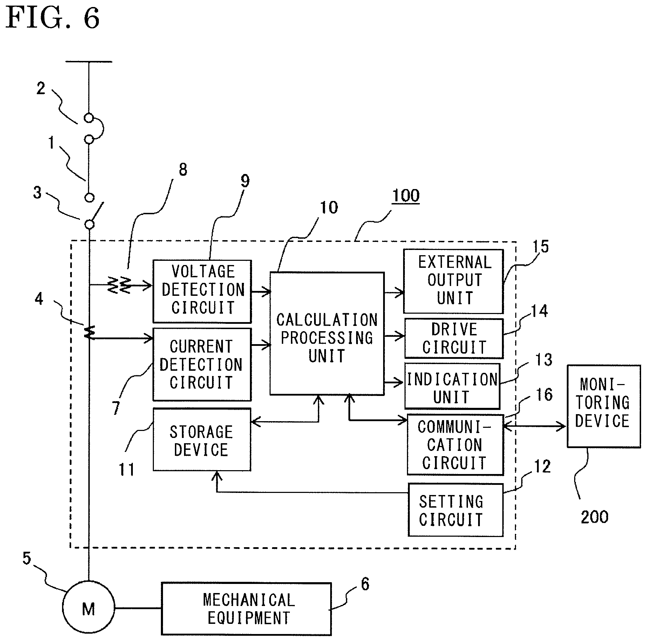

Hereinafter, an electric motor diagnosing device according to embodiment 2 will be described with reference to FIG. 6 to FIG. 9.

FIG. 6 is a circuit configuration diagram showing an electric motor diagnosing device according to embodiment 2, and the difference from embodiment 1 is that the main circuit 1 is provided with an instrument voltage transformer 8 for detecting voltage of the main circuit 1, and the electric motor diagnosing device 100 is provided with a voltage detection circuit 9 connected to the instrument voltage transformer 8. The other configurations are the same as those in embodiment 1.

The voltage detection circuit 9 detects line-to-line voltages of the main circuit 1 of the power supply connected to the electric motor, converts these to predetermined signals such as phase voltages of the electric motor 5, to detect voltage of the electric motor, and outputs the signal to the calculation processing unit 10 and the storage device 11.

The calculation processing unit 10 receives outputs of the current detection circuit 7 and the voltage detection circuit 9, and calculates negative-phase-sequence current, a voltage imbalance rate, and the like through analysis on voltage and current of the electric motor 5, to perform determination and detection for winding short-circuit during operation of the electric motor.

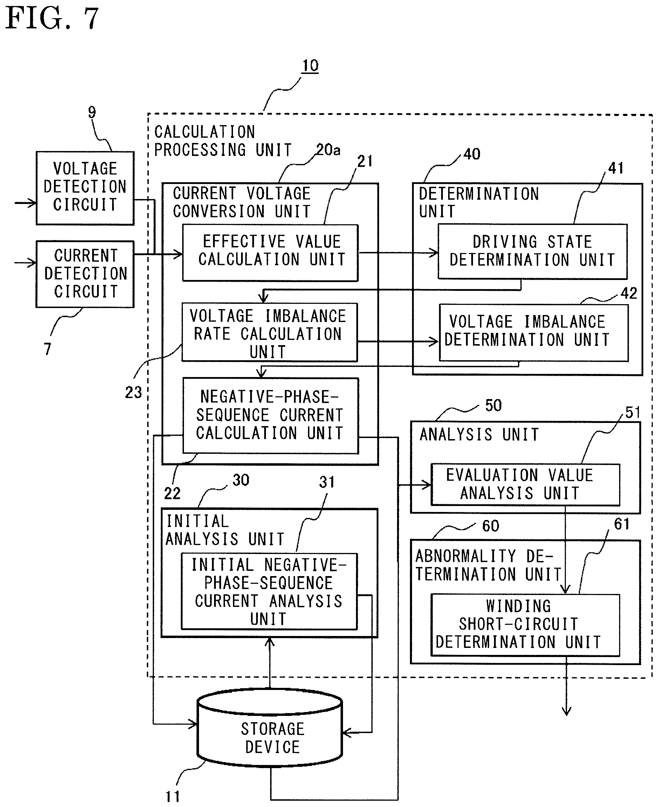

FIG. 7 is a configuration diagram schematically showing the calculation processing unit 10 in the electric motor diagnosing device according to embodiment 2. The calculation processing unit 10 includes a current voltage conversion unit 20a, the initial analysis unit 30, the determination unit 40, the analysis unit 50, and the abnormality determination unit 60.

The current voltage conversion unit 20a includes the effective value calculation unit 21, the negative-phase-sequence current calculation unit 22, and a voltage imbalance rate calculation unit 23, and calculates negative-phase-sequence current Isn by Expression (1) described in embodiment 1 through symmetric coordinate conversion processing on the basis of three-phase currents detected by the current detection circuit 7.

The voltage imbalance rate calculation unit 23 calculates a voltage imbalance rate Vunbal, using phase voltages for the respective phases or line-to-line voltages. In the case of calculating the voltage imbalance rate Vunbal from, for example, line-to-line voltages, the following expression is used.

$$\text{Vunbal} = ((\text{greatest difference between line-to-line voltages and average voltage})/\text{average voltage}) \times 100\%$$

That is, Vunbal is the greatest one of the following:

$$(\text{Vuv}-\text{Vavg})/\text{Vavg} \times 100\%,$$

$$(\text{Vvw}-\text{Vavg})/\text{Vavg} \times 100\%,$$

and

$$(\text{Vwu}-\text{Vavg})/\text{Vavg} \times 100\%.$$

Here, average voltage $\text{Vavg} = (\text{Vuv} + \text{Vvw} + \text{Vwu})/3$.

In addition, Vuv is line-to-line voltage between phase u and phase v, Vvw is line-to-line voltage between phase v and phase w, and Vwu is line-to-line voltage between phase w and phase u.

In the voltage imbalance rate calculation unit 23, it is preferable that the negative-phase-sequence current is calculated only when the voltage imbalance rate Vunbal is not greater than 1%, and the negative-phase-sequence current is not calculated when the voltage imbalance rate is greater than 1%. This is because, if the voltage imbalance rate is great, the negative-phase-sequence current value changes depending on variation in load torque, and therefore there is a high possibility that erroneous detection occurs in winding short-circuit determination. Also for short-circuit determination, limitation is set so that the determination is performed only when the voltage imbalance rate is not greater than, for example, 1%, whereby winding short-circuit determination accuracy can be enhanced.

The initial analysis unit 30 includes the initial negative-phase-sequence current analysis unit 31. The initial negative-phase-sequence current analysis unit 31 analyzes a negative-phase-sequence current value Isn in a normal state before winding short-circuit determination. As in embodiment 1, for example, negative-phase-sequence current values for one month are calculated, and an averaged value thereof is used as an initial negative-phase-sequence current value Isn0.

The determination unit 40 includes the driving state determination unit 41 and a voltage imbalance determination unit 42. The driving state determination unit 41 determines the driving state of the motor on the basis of the effective values of current and voltage calculated by the effective value calculation unit 21. Determination for the driving state of the motor may be performed on the basis of, instead of the effective values of current and voltage, the instantaneous value of current or voltage, or an ON/OFF signal of the electromagnetic contactor 3.

The voltage imbalance determination unit 42 determines whether or not the voltage imbalance rate Vunbal is greater than a predetermined threshold $\delta2$. The threshold $\delta2$ is set at, for example, 1% as described above.

The analysis unit 50 includes the evaluation value analysis unit 51, and performs analysis for determination to be performed in the winding short-circuit determination unit 61 of the abnormality determination unit 60. The evaluation value analysis unit 51 calculates the evaluation value A = |Isn - Isn0| in Expression (8). The calculation method for the evaluation value A is the same as in embodiment 1.

That is, with the initial negative-phase-sequence current Isn0 analyzed, only Isn and Isn0 are measured, and the evaluation value A is used as an index, whereby occurrence of winding short-circuit can be detected.

At this time, by being limited to the case where the voltage imbalance rate Vunbal is not greater than, for example, 1%, detection can be accurately performed. In addition, at the initial period when the electric motor 5 is installed, initialization is performed (negative-phase-sequence admittance Yn is calculated) assuming that winding short-circuit has not occurred yet, and thereafter, the evaluation value A in Expression (8) is monitored to perform determination for winding short-circuit.

The configuration of the abnormality determination unit 60 is the same as that in embodiment 1, i.e., includes the winding short-circuit determination unit 61 and determines whether or not winding short-circuit has occurred on the basis of whether or not the evaluation value A calculated by the evaluation value analysis unit 51 exceeds the predetermined threshold $\delta1$.

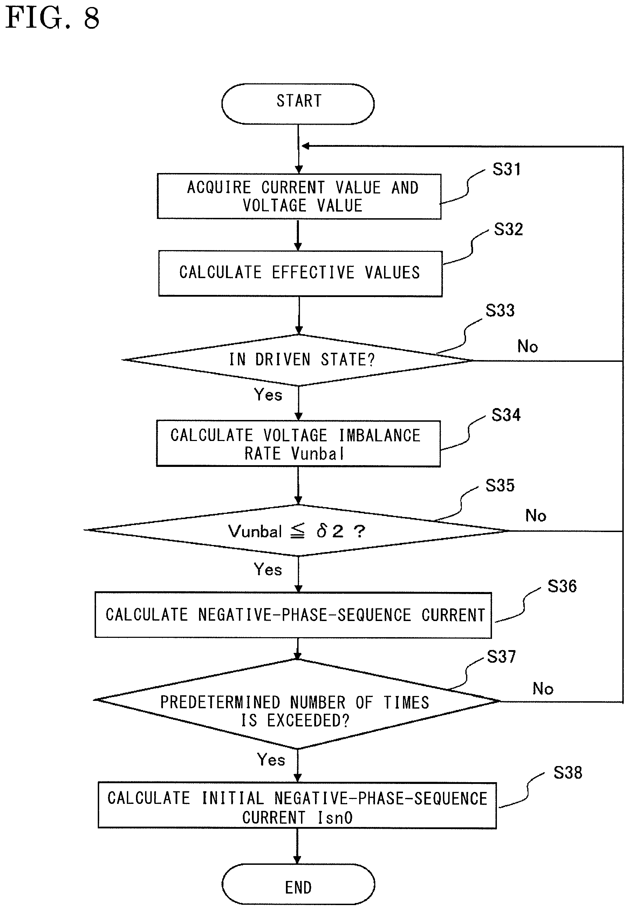

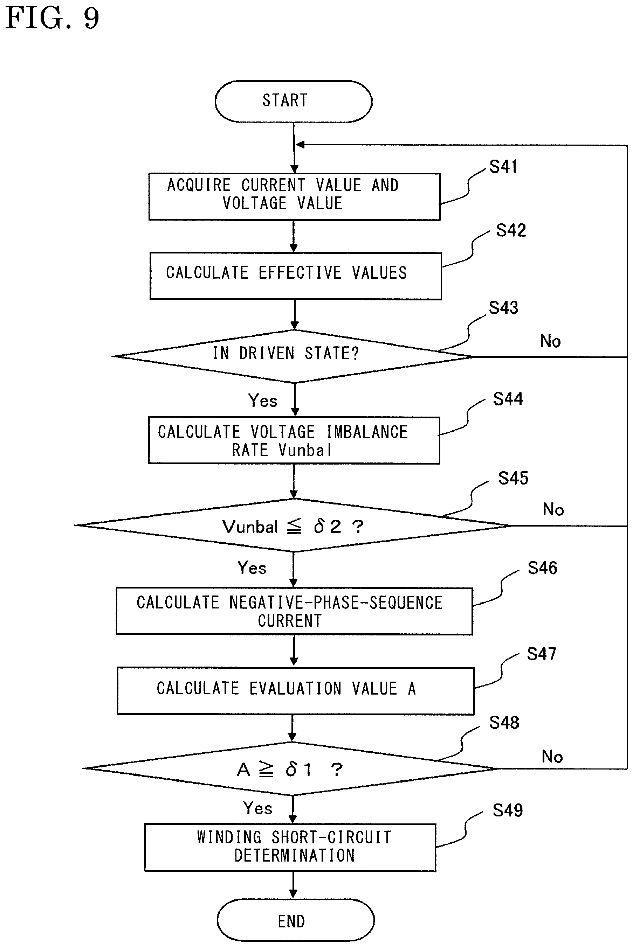

Next, a process for diagnosis using the electric motor diagnosing device 100 will be described with reference to FIG. 8 and FIG. 9.

FIG. 8 is a flowchart for analyzing initial negative-phase-sequence current using the electric motor diagnosing device according to embodiment 2. Current (current for each phase) of the electric motor 5 is acquired by the current detection circuit 7, and voltages (line-to-line voltages or phase voltages) of the electric motor 5 are acquired by the voltage detection circuit 9 (step S31). The effective value calculation unit 21 calculates the effective values of the current and the voltage (step S32). The driving state determination unit 41 determines whether or not the electric motor 5 is in a driven state, on the basis of the effective values of the current and the voltage. If it is determined that the electric motor 5 is in a driven state (Yes in step S33), the voltage imbalance rate calculation unit 23 calculates the voltage imbalance rate Vunbal (step S34).

The voltage imbalance rate Vunbal is compared with the predetermined threshold $\delta2$, and if voltage imbalance rate Vunbal $\leq \delta2$ is satisfied (Yes in step S35), the negative-phase-sequence current calculation unit 22 calculates the negative-phase-sequence current (step S36). Whether or not the number of times the negative-phase-sequence current is calculated exceeds a predetermined number of times is determined, and if it is determined that the predetermined number of times is exceeded (Yes in step S37), the negative-phase-sequence current values for the predetermined number of times are averaged, and the averaged value is used as the initial negative-phase-sequence current value Isn0 (step S38). The initial negative-phase-sequence current value Isn0 is stored in the storage device 11. If the number of times the negative-phase-sequence current is calculated is smaller than the predetermined number of times (No in step S37), current of the electric motor is acquired again to repeat processing from step S31 to step S37 until reaching the predetermined number of times.

After the initial negative-phase-sequence current value Isn0 is calculated, diagnosis for winding short-circuit determination is performed.

FIG. 9 is a flowchart for performing winding short-circuit determination. Current (current for each phase) of the electric motor 5 is acquired by the current detection circuit 7, and voltages (line-to-line voltages or phase voltages) of the electric motor 5 are acquired by the voltage detection circuit 9 (step S41). The effective value calculation unit 21 calculates the effective values of the current and the voltage (step S42). The driving state determination unit 41 determines whether or not the electric motor 5 is in a driven state, on the basis of the effective values of the current value and the voltage value. If it is determined that the electric motor 5 is in a driven state (Yes in step S43), the voltage imbalance rate calculation unit 23 calculates the voltage imbalance rate Vunbal (step S44).

The voltage imbalance rate Vunbal is compared with the predetermined threshold $\delta2$, and if voltage imbalance rate Vunbal $\leq \delta2$ is satisfied (Yes in step S45), the negative-phase-sequence current calculation unit 22 calculates the negative-phase-sequence current Isn (step S46). Next, the evaluation value analysis unit 51 calculates the evaluation value A in Expression (8) from the initial negative-phase-sequence current Isn0 calculated in step S38 in FIG. 8 and stored in the storage device 11 and the negative-phase-sequence current Isn calculated in step S46 (step S47). The winding short-circuit determination unit 61 compares the evaluation value A and the predetermined threshold $\delta1$, and if A $\geq \delta1$ is satisfied (Yes in step S48), the winding short-circuit determination unit 61 determines that winding short-circuit has occurred, and outputs the result to outside (step S49).

In the case of A < 51 in step S48, the process returns to step S41 to acquire current (current for each phase) and voltages (line-to-line voltages or phase voltages) of the electric motor 5 again.

As described above, embodiment 2 provides the same effects as those in embodiment 1. Further, in the case where the voltage imbalance rate Vunbal is unknown or estimated to be great, the voltage imbalance rate Vunbal is calculated, and if the voltage imbalance rate Vunbal is greater than the predetermined threshold $\delta2$, e.g., 1%, short-circuit determination based on the negative-phase-sequence current is not performed. Thus, error in short-circuit determination is suppressed. As a matter of course, if the calculated voltage imbalance rate Vunbal is smaller than the predetermined threshold $\delta 2$, winding short-circuit determination is performed in accordance with the flowcharts shown in FIG. 8 and FIG. 9.

Embodiment 3

In embodiments 1 and 2, the initial negative-phase-sequence current value Isn0 is obtained by being repeatedly calculated a plurality of times (predetermined number of times) and averaged, before winding short-circuit determination is performed. Instead, it is also possible to store initial negative-phase-sequence current values Isn0 by preparing a correspondence table of the voltage imbalance rate and the negative-phase-sequence current for each type and each rating of an electric motor.

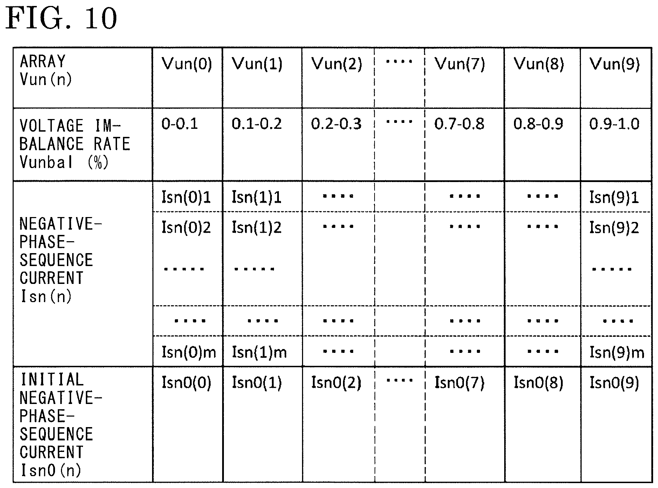

FIG. 10 shows, in a table format, the correspondence relationship between the voltage imbalance rate and the negative-phase-sequence current. First, a method for preparing this table will be described. A row of array Vun(n) and a row of voltage imbalance rate Vunbal are prepared. In the case where the threshold $\delta 2$ predetermined for the voltage imbalance rate Vunbal is 1%, the ranges of the voltage imbalance rates Vunbal (%) corresponding to ten equally divided arrays Vun(0), Vun(1), Vun(2), ..., Vun(7), Vun(8), Vun(9) are $0 \leq$ Vunbal $\leq 0.1$, $0.1 <$ Vunbal $\leq 0.2$, $0.2 <$ Vunbal $\leq 0.3$, ..., $0.7 <$ Vunbal $\leq 0.8$, $0.8 <$ Vunbal $\leq 0.9$, $0.9 <$ Vunbal $\leq 1.0$, respectively.

Regarding an electric motor of type P and rating Q, the voltage imbalance rate is calculated, and if the voltage imbalance rate is not greater than 1%, the negative-phase-sequence current is calculated. The negative-phase-sequence current value and the voltage imbalance rate are stored as a set. Then, the negative-phase-sequence current and the voltage imbalance rate are stored for a certain period, and thereafter, the average of the negative-phase-sequence current is calculated for each voltage imbalance rate, whereby the initial negative-phase-sequence current value for each voltage imbalance rate is determined. For example, the negative-phase-sequence current value Isn(1)1 when the voltage imbalance rate is 0.15% is stored in the column of negative-phase-sequence current Isn(1) in the array Vun(1). When calculation has been performed a predetermined number of times m in the array Vun(1), the m values of negative-phase-sequence current Isn(1) corresponding to Vun(1) are averaged to obtain Isn0(1). In this way, the initial negative-phase-sequence currents Isn0(n) corresponding to the ten divided arrays Vun(n) are calculated to obtain a table.

In the case of performing winding short-circuit determination for an electric motor of type P and rating Q, for example, in accordance with the flowchart in FIG. 9, the voltage imbalance rate is calculated in step S44. The initial negative-phase-sequence current value corresponding to the calculated voltage imbalance rate is read from the table stored in the storage device 11. Using the read initial negative-phase-sequence current value and the negative-phase-sequence current calculated in step S46, the evaluation value A = |Isn - Isn0| is calculated in step S47, to perform winding short-circuit determination.

In an electric motor for which the voltage imbalance rate has been acquired at the time of preparing the table of the correspondence relationship between the voltage imbalance rate and the negative-phase-sequence current shown in FIG. 10 above, a system of a control center using the electric motor, or a system in which the voltage imbalance rate is already known, it is possible to use the values in the table on the basis of the type and the rating of the electric motor and the voltage imbalance rate, without calculating the initial negative-phase-sequence current value.

As described above, according to embodiment 3, it becomes possible to perform winding short-circuit determination without calculating the initial negative-phase-sequence current value before winding short-circuit determination.

It is understood that numerous modifications which have not been exemplified can be devised without departing from the scope of the present invention, which is defined by the appended claims.

DESCRIPTION OF THE REFERENCE CHARACTERS

    1 main circuit
    2 circuit breaker
    3 electromagnetic contactor
    4 instrument transformer
    5 electric motor
    6 mechanical equipment
    7 current detection circuit
    8 instrument voltage transformer
    9 voltage detection circuit
    10 calculation processing unit

11 storage device
12 setting circuit
13 indication unit
14 drive circuit
15 external output unit
16 communication circuit
20 current conversion unit
20a current voltage conversion unit
21 effective value calculation unit
22 negative-phase-sequence current calculation unit
23 voltage imbalance rate calculation unit
30 initial analysis unit
31 initial negative-phase-sequence current analysis unit
40 determination unit
41 driving state determination unit
42 voltage imbalance determination unit
50 analysis unit
51 evaluation value analysis unit
60 abnormality determination unit
61 winding short-circuit determination unit
100 electric motor diagnosing device
200 monitoring device

## Claims

1. An electric motor diagnosing device (100) comprising:

   a current detection circuit (7) for detecting current of an electric motor (5);
   a voltage detection circuit (9) for detecting voltage of the electric motor (5); and
   a calculation processing unit (10) which receives output of the current detection circuit (7) and performs determination for winding short-circuit abnormality in the electric motor (5), wherein
   the calculation processing unit (10) includes

   a driving state determination unit (41) which calculates an effective value from current and voltage of the electric motor (5) to determine whether or not the electric motor (5) is in a driven state,
   a voltage imbalance rate determination unit (42) which calculates a voltage imbalance rate from voltage of the electric motor and compares the calculated voltage imbalance rate and a set threshold to determine whether or not to perform winding short-circuit determination, **characterised by**
   an initial negative-phase-sequence current analysis unit (31) which, when the voltage imbalance rate determination unit (42) determines that winding short-circuit determination is to be performed, obtains an initial negative-phase-sequence current, the initial negative-phase-sequence current being an average value of negative-phase-sequence current in a normal state of the electric motor (5),
   an evaluation value analysis unit (51) which, when the voltage imbalance rate determination unit (42) determines that winding short-circuit determination is to be performed, calculates an evaluation value for winding short-circuit on the basis of a difference between negative-phase-sequence current calculated from the current of the electric motor (5) detected by the current detection circuit (7) in the driven state and the initial negative-phase-sequence current, and
   a winding short-circuit determination unit (61) which performs determination for winding short-circuit of the electric motor (5) through comparison between the evaluation value and a set threshold.

2. The electric motor diagnosing device (100) according to claim 1, further comprising a storage device (11) which stores a table obtained by acquiring, in advance, negative-phase-sequence current for each predetermined voltage imbalance rate range, for each type and each rating of an electric motor, and averaging a plurality of the acquired negative-phase-sequence currents, to set the averaged value as an initial negative-phase-sequence current value for each voltage imbalance rate range, wherein
   when the voltage imbalance rate determination unit (42) determines that winding short-circuit determination is to be performed, the initial negative-phase-sequence current analysis unit (31) reads, from the storage device (11), the table prepared for each type and each rating of the electric motor and storing the initial negative-phase-sequence current value for each predetermined voltage imbalance rate range, and uses the read initial negative-phase-sequence current value as a value of initial negative-phase-sequence current corresponding to the calculated voltage imbalance rate.

## Patentansprüche

1. Elektromotor-Diagnoseeinrichtung (100), aufweisend:

eine Stromdetektionsschaltung (7) zur Detektion eines Stroms eines Elektromotors (5);
eine Spannungsdetektionsschaltung (9) zur Detektion einer Spannung des Elektromotors (5); und
eine Berechnungsverarbeitungseinheit (10), die das Ausgangssignal der Stromdetektionsschaltung (7) empfängt und eine Bestimmung für eine Wicklungskurzschlussanomalie in dem Elektromotor (5) durchführt, wobei die Berechnungsverarbeitungseinheit (10) aufweist

eine Antriebszustandsbestimmungseinheit (41), die einen effektiven Wert aus Strom und Spannung des Elektromotors (5) berechnet, um zu bestimmen, ob sich der Elektromotor (5) in einem angetriebenen Zustand befindet oder nicht,
eine Spannungsungleichgewichtsraten-Bestimmungseinheit (42), die eine Spannungsungleichgewichtsrate aus der Spannung des Elektromotors berechnet und die berechnete Spannungsungleichgewichtsrate und einen eingestellten Schwellwert vergleicht, um zu bestimmen, ob eine Wicklungskurzschlussbestimmung durchgeführt werden soll oder nicht, **gekennzeichnet durch**
eine Anfänglicher-Gegenphasenstrom-Analyseeinheit (31), die, wenn die Spannungsungleichgewichtsraten-Bestimmungseinheit (42) bestimmt, dass eine Wicklungskurzschlussbestimmung durchgeführt werden soll, einen Anfänglicher-Gegenphasenstrom ermittelt, wobei der Anfänglicher-Gegenphasenstrom ein Durchschnittswert des Gegenphasenstroms in einem normalen Zustand des Elektromotors (5) ist,
eine Bewertungswert-Analyseeinheit (51), die, wenn die Spannungsungleichgewichtsraten-Bestimmungseinheit (42) bestimmt, dass eine WicklungskurzschlussBestimmung durchgeführt werden soll, einen Bewertungswert für einen Wicklungskurzschluss auf der Grundlage einer Differenz zwischen dem Gegenphasenstrom, der aus dem Strom des Elektromotors (5) berechnet wird, der von der Stromdetektionsschaltung (7) im angetriebenen Zustand erfasst wird, und dem anfänglichen Gegenphasenstrom berechnet wird, und
eine Wicklungskurzschlussbestimmungseinheit (61), die eine Bestimmung für einen Wicklungskurzschluss des Elektromotors (5) durch Vergleich zwischen dem Bewertungswert und einem eingestellten Schwellwert durchführt.

2. Elektromotor-Diagnoseeinrichtung (100) nach Anspruch 1, des Weiteren mit

einer Speichereinrichtung (11), die eine Tabelle speichert, die durch vorheriges Erfassen des Gegenphasenstroms für jeden vorbestimmten Spannungsungleichgewichtsratenbereich, für jeden Typ und jede Leistung eines Elektromotors, und durch Mittelwertbildung einer Vielzahl der erfassten Gegenphasenströme erhalten wird, um den gemittelten Wert als einen Anfänglicher-Gegenphasenstromwert für jeden Spannungsungleichgewichtsratenbereich festzulegen, wobei
wenn die Spannungsungleichgewichtsraten-Bestimmungseinheit (42) bestimmt, dass Wicklungskurzschlussbestimmung durchgeführt werden soll, die Anfänglicher-Gegenphasenstrom-Analyseeinheit (31) die Tabelle, die für jeden Typ und jede Leistung des Elektromotors vorbereitetet ist und den Anfänglicher-Gegenphasenstromwert für jeden vorbestimmten Spannungsungleichgewichtsratenbereich speichert, aus der Speichereinrichtung (11) ausliest, und den ausgelesenen Wert des Anfänglicher-Gegenphasenstroms als einen Wert des Anfänglicher-Gegenphasenstroms verwendet, der der berechneten Spannungsungleichgewichtsrate entspricht.

## Revendications

1. Dispositif de diagnostic de moteur électrique (100) comprenant :

un circuit de détection de courant (7) pour détecter un courant d'un moteur électrique (5) ;
un circuit de détection de tension (9) pour détecter une tension du moteur électrique (5) ; et

une unité de traitement de calcul (10) qui reçoit une sortie du circuit de détection de courant (7) et réalise une détermination d'anomalie de court-circuit d'enroulement dans le moteur électrique (5), dans lequel l'unité de traitement de calcul (10) comporte

une unité de détermination d'état d'entraînement (41) qui calcule une valeur effective à partir d'un courant et d'une tension du moteur électrique (5) pour déterminer que le moteur électrique (5) est ou non dans un état entraîné,

une unité de détermination de taux de déséquilibre de tension (42) qui calcule un taux de déséquilibre de tension à partir d'une tension du moteur électrique et compare le taux de déséquilibre de tension calculé et un seuil défini pour déterminer qu'il convient ou non de réaliser une détermination de court-circuit d'enroulement, **caractérisé par**

une unité d'analyse de courant initial de séquence de phase négative (31) qui, lorsque l'unité de détermination de taux de déséquilibre de tension (42) détermine qu'une détermination de court-circuit d'enroulement doit être réalisée, obtient un courant initial de séquence de phase négative, le courant initial de séquence de phase négative étant une valeur moyenne de courant de séquence de phase négative dans un état normal du moteur électrique (5),

une unité d'analyse de valeur d'évaluation (51) qui, lorsque l'unité de détermination de taux de déséquilibre de tension (42) détermine qu'une détermination de court-circuit d'enroulement doit être réalisée, calcule une valeur d'évaluation du court-circuit d'enroulement en fonction d'une différence entre le courant de séquence de phase négative calculé à partir du courant du moteur électrique (5) détecté par le circuit de détection de courant (7) dans l'état entraîné et le courant initial de séquence de phase négative, et

une unité de détermination de court-circuit d'enroulement (61) qui réalise une détermination de court-circuit d'enroulement du moteur électrique (5) par comparaison entre la valeur d'évaluation et un seuil défini.

2. Dispositif de diagnostic de moteur électrique (100) selon la revendication 1, comprenant en outre un dispositif de stockage (11) qui stocke une table obtenue en acquérant, à l'avance, un courant de séquence de phase négative pour chaque plage de taux de déséquilibre de tension prédéterminée, pour chaque type et chaque puissance nominale d'un moteur électrique, et en moyennant une pluralité des courants de séquence de phase négative acquis, pour définir la valeur moyenne comme valeur de courant initial de séquence de phase négative pour chaque plage de taux de déséquilibre de tension, dans lequel

lorsque l'unité de détermination de taux de déséquilibre de tension (42) détermine qu'une détermination de court-circuit d'enroulement doit être réalisée, l'unité d'analyse de courant initial de séquence de phase négative (31) lit, à partir du dispositif de stockage (11), la table préparée pour chaque type et chaque puissance nominale du moteur électrique et stockant la valeur de courant initial de séquence de phase négative pour chaque plage de taux de déséquilibre de tension prédéterminée, et utilise la valeur de courant initial de séquence de phase négative lue comme valeur de courant initial de séquence de phase négative correspondant au taux de déséquilibre de tension calculé.

# FIG. 1

# FIG. 2

# FIG. 3

CALCULATION PROCESSING UNIT 10

CURRENT DETEC- TION CIRCUIT 7

CURRENT CONVER- SION UNIT 20 21
EFFECTIVE VALUE CALCULATION UNIT

NEGATIVE-PHASE- SEQUENCE CURRENT CALCULATION UNIT 22

DETERMINA- TION UNIT 40 41
DRIVING STATE DETERMINATION UNIT

INITIAL ANALYSIS UNIT 30 31
INITIAL NEGATIVE- PHASE-SEQUENCE CURRENT ANALYSIS UNIT

ANALYSIS UNIT 50 51
EVALUATION VALUE ANALYSIS UNIT

ABNORMALITY DETERMINATION UNIT 60 61
WINDING SHORT-CIRCUIT DETERMINATION UNIT

STORAGE DEVICE 11

# FIG. 4

```
                    ┌──────────────┐
                    │    START     │
                    └──────┬───────┘
                           │
            ┌──────────────▼──────────────┐      S11
            │    ACQUIRE CURRENT VALUE     │
            └──────────────┬──────────────┘
                           │                      S12
            ┌──────────────▼──────────────┐
            │   CALCULATE EFFECTIVE VALUE  │
            └──────────────┬──────────────┘
                           │                      S13
                      ◇────────────◇          No
                  ◇   IN DRIVEN STATE?  ◇─────────────┐
                      ◇────────────◇                  │
                           │ Yes                      │
            ┌──────────────▼──────────────┐  S14       │
            │         CALCULATE           │            │
            │ NEGATIVE-PHASE-SEQUENCE CURRENT │         │
            └──────────────┬──────────────┘            │
                           │                  S15       │
                      ◇────────────◇            No      │
                  ◇ PREDETERMINED NUMBER OF TIMES ◇─────┤
                  ◇    IS EXCEEDED?    ◇                 │
                      ◇────────────◇                     
                           │ Yes
            ┌──────────────▼──────────────┐  S16
            │ CALCULATE INITIAL NEGATIVE-PHASE- │
            │   SEQUENCE CURRENT Isn0     │
            └──────────────┬──────────────┘
                           │
                    ┌──────▼───────┐
                    │     END      │
                    └──────────────┘
```

# FIG. 5

START

ACQUIRE CURRENT VALUE — S21

CALCULATE EFFECTIVE VALUE — S22

IN DRIVEN STATE? — S23
No
Yes

CALCULATE
NEGATIVE-PHASE-SEQUENCE CURRENT — S24

CALCULATE EVALUATION VALUE A — S25

$A \geqq \delta 1$ ? — S26
No
Yes

WINDING SHORT-CIRCUIT
DETERMINATION — S27

END

# FIG. 6

# FIG. 7

# FIG. 8

START

ACQUIRE CURRENT VALUE AND VOLTAGE VALUE — S31

CALCULATE EFFECTIVE VALUES — S32

IN DRIVEN STATE? — S33
No
Yes

CALCULATE VOLTAGE IMBALANCE RATE Vunbal — S34

Vunbal $\leqq \delta 2$ ? — S35
No
Yes

CALCULATE NEGATIVE-PHASE-SEQUENCE CURRENT — S36

PREDETERMINED NUMBER OF TIMES IS EXCEEDED? — S37
No
Yes

CALCULATE INITIAL NEGATIVE-PHASE-SEQUENCE CURRENT Isn0 — S38

END

## FIG. 9

```
                    ┌─────────────┐
                    │    START    │
                    └──────┬──────┘
                           │
                           ▼
              ┌────────────────────────────┐  S41
              │  ACQUIRE CURRENT VALUE AND  │
              │        VOLTAGE VALUE        │
              └────────────┬───────────────┘
                           │
                           ▼
              ┌────────────────────────────┐  S42
              │   CALCULATE EFFECTIVE VALUES │
              └────────────┬───────────────┘
                           │
                           ▼                     S43
                    ◇ IN DRIVEN STATE? ◇──────── No
                           │ Yes
                           ▼
              ┌────────────────────────────┐  S44
              │  CALCULATE VOLTAGE IMBALANCE │
              │         RATE Vunbal         │
              └────────────┬───────────────┘
                           │
                           ▼                     S45
                    ◇ Vunbal ≦ δ2 ? ◇──────── No
                           │ Yes
                           ▼
              ┌────────────────────────────┐  S46
              │  CALCULATE NEGATIVE-PHASE-  │
              │      SEQUENCE CURRENT       │
              └────────────┬───────────────┘
                           │
                           ▼
              ┌────────────────────────────┐  S47
              │   CALCULATE EVALUATION VALUE A │
              └────────────┬───────────────┘
                           │
                           ▼                     S48
                    ◇ A ≧ δ1 ? ◇──────── No
                           │ Yes
                           ▼
              ┌────────────────────────────┐  S49
              │   WINDING SHORT-CIRCUIT     │
              │       DETERMINATION         │
              └────────────┬───────────────┘
                           │
                           ▼
                    ┌─────────────┐
                    │     END     │
                    └─────────────┘
```

# FIG. 10

| ARRAY Vun (n) | Vun(0) | Vun(1) | Vun(2) | ···· | Vun(7) | Vun(8) | Vun(9) |
|---|---|---|---|---|---|---|---|
| VOLTAGE IM-BALANCE RATE Vunbal (%) | 0-0.1 | 0.1-0.2 | 0.2-0.3 | ···· | 0.7-0.8 | 0.8-0.9 | 0.9-1.0 |
| NEGATIVE-PHASE-SEQUENCE CURRENT Isn (n) | Isn(0)1 | Isn(1)1 | ···· | | ···· | ···· | Isn(9)1 |
| | Isn(0)2 | Isn(1)2 | ···· | | ···· | ···· | Isn(9)2 |
| | ····· | ····· | | | | | ····· |
| | ···· | ···· | ···· | | ···· | ···· | ···· |
| | Isn(0)m | Isn(1)m | ···· | | ···· | ···· | Isn(9)m |
| INITIAL NEGATIVE-PHASE-SEQUENCE CURRENT Isn0 (n) | Isn0(0) | Isn0(1) | Isn0(2) | ···· | Isn0(7) | Isn0(8) | Isn0(9) |

**EP 3 783 376 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6099852 B

- CN 106291352 A

**Non-patent literature cited in the description**

- Characterization of short circuit faults and incipient insulation degradation between stator winding turns of induction motor. **DAS SANTANU et al.** 2013 IEEE 1ST INTERNATIONAL CONFERENCE ON CONDITION ASSESSMENT TECHNIQUES IN ELECTRICAL SYSTEMS (CATCON). IEEE, 06 December 2013, 54-59

- Practical issues on negative sequence current monitoring for condition monitoring in induction motors. **BAKHRI S et al.** UNIVERSITIES POWER ENGINEERING CONFERENCE (AUPEC), 2012 22ND AUSTRALASIAN. IEEE, 26 September 2012, 1-6